# EUROPEAN PATENT SPECIFICATION

(11) **EP 2 246 884 B1**
(45) Date of publication and mention of the grant of the patent: **31.07.2013**
(21) Application number: 09706773.0
(22) Date of filing: 30.01.2009
(51) Int. Cl.: H01L 23/12, H01L 23/02, H01L 23/66, H01L 23/64, H05K 9/00

(54) **HIGH FREQUENCY WIRING BOARD**
HOCHFREQUENZ-LEITERPLATTE
CARTE DE CÂBLAGE HAUTE FRÉQUENCE

(30) Priority: 30.01.2008 JP 2008018807
(43) Date of publication of application: 03.11.2010
(73) Proprietor: Kyocera Corporation, Kyoto-shi Kyoto 612-8501 (JP)
(72) Inventor: SHIRASAKI, Takayuki, Kirishima-shi Kagoshima 8994396 (JP)
(74) Representative: Beetz & Partner
(86) International application number: PCT/JP2009/051664
(87) International publication number: WO 2009/096568

(56) References cited:
- JP-A- 2001 102 489
- JP-A- 2003 282 755
- JP-A- 2005 038 984
- US-A1- 2004 085 150
- US-A1- 2005 128 022

## Description

### Technical Field

The present invention relates to a high frequency wiring board having a function of terminating a high frequency signal with a terminating resistor, particularly to a high frequency wiring board for use in a high frequency band of 20 GHz or more, and to a device employing the same.

### Background Art

As an example of using a heretofore known high frequency wiring board, a description will be given referring to a semiconductor device for use in the optical communications or wireless communications field.

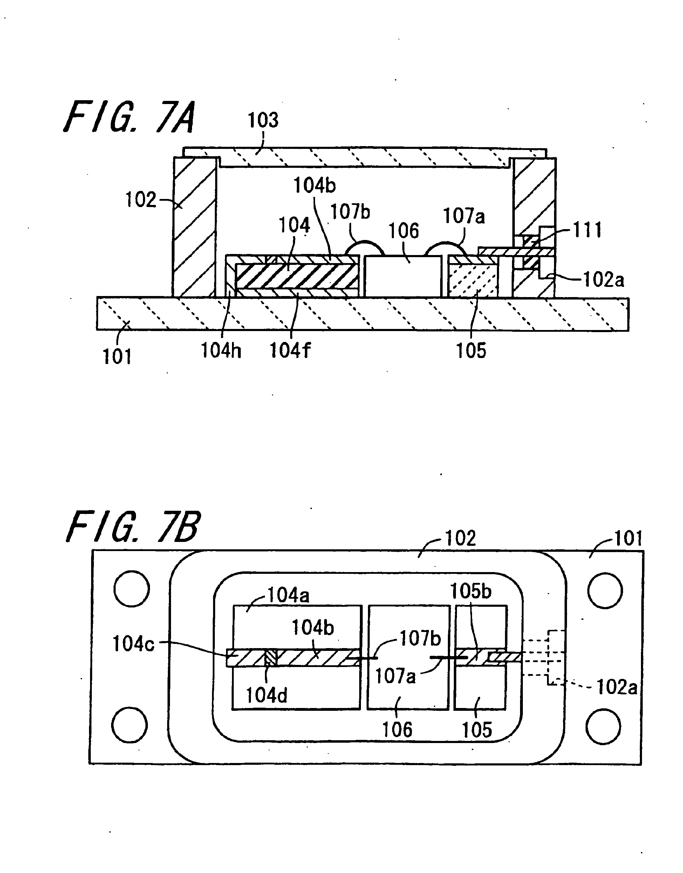

A package for housing a semiconductor device which houses various kinds of semiconductor devices has a built-in high frequency wiring board provided with a line conductor which is formed by a conductor pattern on an insulator surface in order to electrically connect a semiconductor device. Sectional and plan views of this kind package for housing of the semiconductor device are shown in Figs. 7A and 7B. The package for housing the semiconductor device has a base 101, a metal frame 102, a lid body 103, a high frequency wiring board 104, and a line conductor 104b.

A semiconductor device 106 such as an IC, an LSI, a semiconductor laser (LD), or a photodiode (PD), and the high frequency wiring board 104 are mounted on an upper side main surface of the base 101. An electrode of the semiconductor device 106 is electrically connected via a bonding wire 107b to the line conductor 104b on the high frequency wiring board 104.

Furthermore, a ground conductor 104c provided in a portion which is an extension of an end of the line conductor 104b, and the end of the line conductor 104b, are terminally connected via a terminating resistor 104d. The ground conductor 104c is electrically connected to the base 101 via a connection conductor 104h and a ground conductor 104f formed, respectively, on a side surface and the lower surface of the high frequency wiring board 104. The terminating resistor 104d has an object of reducing reflection of a high frequency signal flowing through the line conductor 104b, thus preventing the semiconductor device 106 from malfunctioning (for example, refer to Japanese Unexamined Patent Publication JP-A-2002-319645).

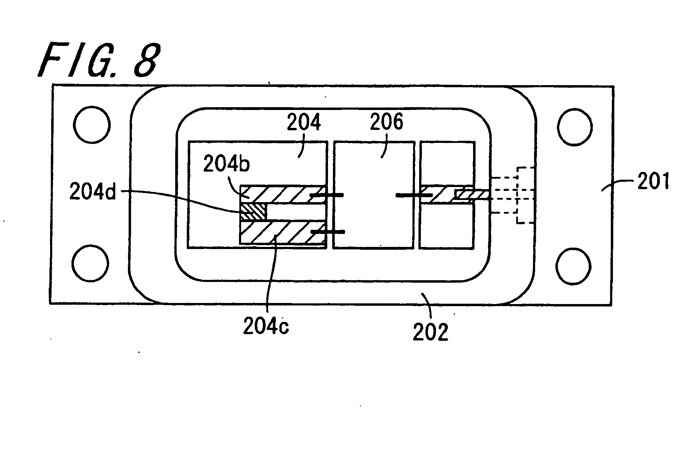

In response to this, a high frequency wiring board 204 shown in Fig. 8 has been proposed. In Fig. 8, reference numeral 204b denotes a line conductor formed on the upper surface of the high frequency wiring board 204, reference numeral 204c denotes a ground conductor formed aligned with one side surface of the line conductor 204b and maintaining a constant interval therewith, and reference numeral 204d denotes a terminating resistor connecting the ground conductor 204c and line conductor 204b at one side surface of an end portion of the line conductor 204b. An object is to reduce the effect of a parasitic inductance component held by the terminating resistor 204d, thus improving terminating characteristics, by increasing the capacitive coupling of the line conductor 204b and ground conductor 204c (for example, refer to Japanese Unexamined Patent Publication JP-A-2005-159127).

However, in a package for housing a semiconductor device used in the heretofore known high frequency wiring board 204 shown in Fig. 8, a new problem occurs in that the terminating characteristics of the line conductor 204b become insufficient as a further increase in frequency of the semiconductor device 206 progresses, and it may happen that the semiconductor device 206 ceases to operate normally.

US 2004/0085150 discloses a pattern having a center conductor strip generally centered on a KQ ribbon and two adjacent ground strips. The termination proper is formed by depositing either two Z₀ resistors, each going at right angles from the center conductor to the adjacent ground strips; or one Z₀ resistor extending beyond the end of the center conductor to reach the grounded strips that wrap around the distal end.

US 2005/0128022 discloses a coplanar line which comprises a neutral wire and two outer conductors situated at least from section to section on both sides of the neutral wire. The line termination of this coplanar line includes at least one resistor element via which the neutral wire is connected at its end with the two outer conductors.

JP 2003 282755 A discloses a package for housing semiconductor element, which comprises a substrate having a placing section for placing the semiconductor element and a circuit board on its upper main surface. Beside, a line conductor and a ground conductor surrounding the line conductor are formed on the upper surface of the circuit board. The line conductor is connected to the semiconductor element on one end side and to the ground conductor through high-resistance sections on the other end side.

JP 2005 038984 A discloses an optical transmission module which comprises a substrate on which optical element and a transmission line are provided. Besides, a resistance element forming the termination of the transmission line is provided, and a coplanar split-type ground line is disposed near the side of the resistance element.

### Disclosure of the Invention

The invention having been accomplished bearing in mind the above-described problems, an object thereof is to provide a high frequency wiring board, a package for housing an electronic component, and a device employing the same which have good terminating characteristics even in a high frequency band, and in which an electronic device operates normally.

This object is accomplished by the features of claim 1.

### Brief Description of Drawings

Other and further objects, features, and advantages of the invention will be more explicit from the following detailed description taken with reference to the drawings wherein:
Fig. 1A is a sectional view showing one example of an electronic device useful for understanding the invention;
Fig. 1B is a plan view of the electronic device shown in Fig. 1A;
Fig. 2 is a plan view showing an example of a high frequence wiring board according to a first embodiment of the invention;
Fig. 3A is a plan view showing another example of a high frequency wiring board according to an embodiment of the invention;
Fig. 3B is a plan view showing still another example of a high frequency wiring board;
Fig. 4A is a sectional view showing a package suitable for mounting a wiring board accordling to an embodiment of the invention;
Fig. 4B is a plan view of the package shown in Fig.4A;
Fig. 5 is a circuit block diagram showing one example of a communication apparatus comprising a high-frequency wiring board according to an embodiment of the invention;
Fig. 6 is a plan view showing a high frequency wiring board according to one embodiment of the invention;
Fig. 7A is a sectional view showing an example of a heretofore known semiconductor device;
Fig. 7B is a plan view of the heretofore known semiconductor device shown in Fig. 7A; and
Fig. 8 is a plan view showing another example of a heretofore known semiconductor device.

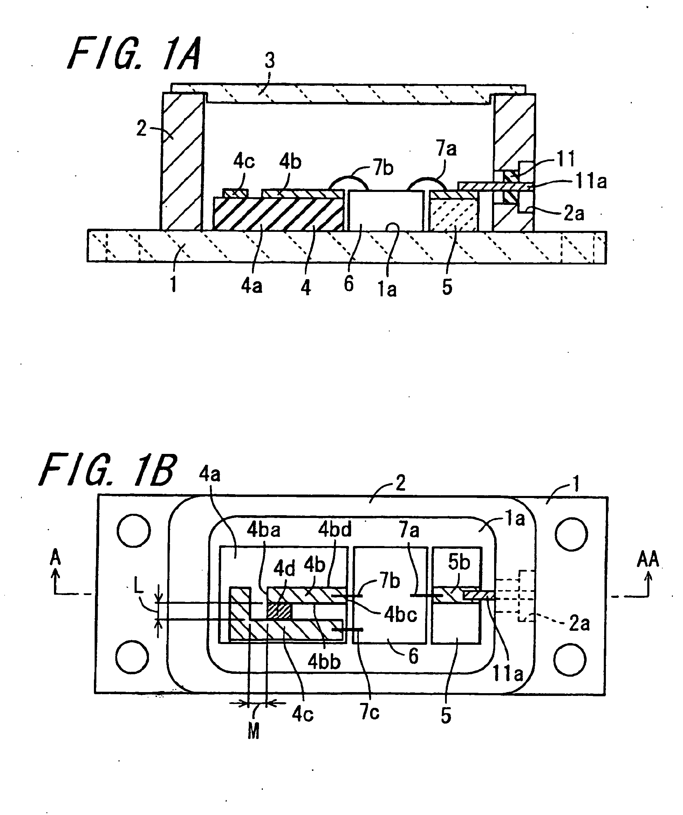

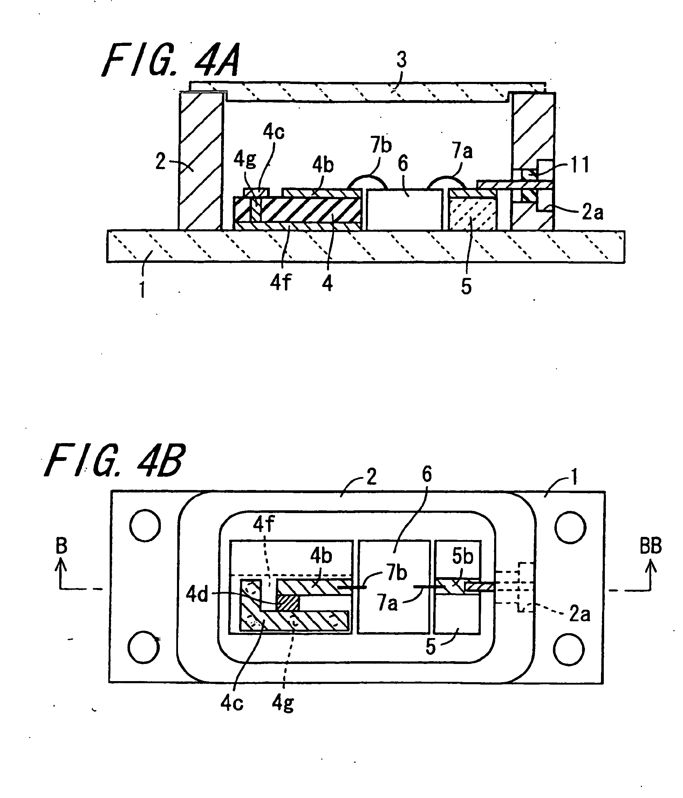

Figs. 1A and 4A show cross-sections A-AA and B-BB of Figs. 1B and 4B, respectively. In Figs. 1B, 2, 3A, 3B, and 4B, hatching is applied to conductive portions such as a line conductor 4b, a ground conductor 4c, and a terminating resistor 4d, in order to facilitate understanding. Consequently, the hatchings do not indicate cross-sections.

### Best Mode for Carrying Out the Invention

Hereafter, using the drawings, a detailed description will be given of the invention.

As shown in these drawings, the electronic device has a base 1, a frame 2, a lid body 3, the high frequency wiring board 4 of the invention, and a semiconductor device 6 as an example of an electronic component. Hereafter, a description will be given of an example wherein the high frequency semiconductor device 6 is used as an electronic component 6.

A package suitable for housing an electronic component according to an embodiment of the invention comprises the base 1, the high frequency wiring board 4, and the frame 2, and the electronic device is configured by placing the semiconductor device 6 on the package for housing the electronic component, and sealing off the interior of the package for housing the electronic component (hereafter occasionally referred to simply as the package) with the lid body 3.

Also, the hiqh frequency wiring board 4 has a dielectric substrate 4a, and the line conductor 4b for high frequency signal transmission formed on one main surface (the upper surface) of the dielectric substrate 4a from a connection terminal connected to an electrode of the semiconductor device 6 to an end 4ba. Also, the high frequency wiring board 4 further has the line-shaped ground conductor 4c, disposed on the one main surface of the dielectric substrate 4a, formed in such a way as to wrap around from one side 4bb of the line conductor 4b to the end 4ba side, and the terminating resistor 4d which electrically connects an end portion of the line conductor 4b and the ground conductor 4c.

The line conductor 4b is formed of a conductor pattern having a line width which provides an impedance appropriate for high frequency transmission. The end 4ba (one end 4ba) of the line conductor 4b is made an open end, as shown in Figs. 1A and 1B, and the electrode of the semiconductor device 6 is connected via a bonding wire 7b or the like to a connection end 4bc (other end 4bc) on the side opposite the end 4ba.

The line-shaped ground conductor 4c is disposed in the same plane as the line conductor 4b, along one side surface 4bb, of side surfaces following the line direction of the line conductor 4b, in a position across a constant interval L. The ground conductor 4c is formed aligned with the one side 4bb of the line conductor 4b and, after being extended by a distance M longer than the end 4ba of the line conductor 4b, is extended in such a way as to wrap around perpendicularly on the end 4ba side of the line conductor 4b. Then, after being extended at least as far as over an extension line of a side surface 4bd on the side opposite the one side 4bb of the line conductor 4b, the ground conductor 4c is terminated as an open end.

The ground conductor 4c may be formed in such a way as to wrap around from the one side 4bb of the line conductor 4b to the end 4ba as wiring of a predetermined width, and may also be formed with a large width from a position separated a predetermined distance from the one side 4bb and end 4ba of the line conductor 4b to a side surface position of the dielectric substrate 4a. Also, although the ground conductor 4c may also be formed in such a way as to further wrap around from the end 4ba of the line conductor 4b to the side surface 4bd side of the line conductor 4b, it is sufficient that it is formed in such a way as to be wrapped around to a position opposing the end 4ba, as shown in Fig. 1B.

The terminating resistor 4d is formed at an end portion of the end 4ba side of the line conductor 4b, between the one side 4bb of the line conductor 4b and a portion of the ground conductor 4c opposing the one side 4bb, connecting the end portion of the line conductor 4b and the ground conductor 4c. Normally, the terminating resistor 4d is formed as far as possible at the end of the line conductor 4b in order to align an end surface of the terminating resistor 4d with the position of the end 4ba of the line conductor 4b, as shown in Fig. 1B, but when necessary, it may also be formed so as to be shifted to the connection end 4bc side.

As the ground conductor 4c is disposed at the end 4ba of the line conductor 4b in such a way as to block the extension direction of the line conductor 4b, the electromagnetic field of the end 4ba of the line conductor 4b is strongly coupled to the ground conductor 4c. This makes it possible to bring about a capacitive coupling between the end of the line conductor 4b and the ground conductor 4c, and reduce the effect of an inductance component parasitic on the terminating resistor 4d portion. As a result, the terminating characteristics of the terminating resistor 4d are good, even when transmitting a high frequency signal of 20 GHz or more. Also, as the coupling of the line conductor 4b and ground conductor 4c is strong at the end 4ba of the line conductor 4b, it is difficult for electromagnetic waves to be radiated from the end 4ba into the package. This makes it possible to reduce the radiation of electromagnetic waves into the package, and to reduce the effect of radiated electromagnetic waves on the operation of the semiconductor device 6, and the like.

At this time, when forming the distance M between the end 4ba of the line conductor 4b and the ground conductor 4c narrower so that the distance M is equal to or smaller than the distance L between the one side 4bb of the line conductor 4b and the ground conductor 4c, the capacitive coupling of the end 4ba of the line conductor 4b and the terminating resistor 4d also becomes stronger, and as a result of further counteracting the parasitic inductance component held by the terminating resistor 4d, the termination characteristics of the terminating resistor 4d are further improved.

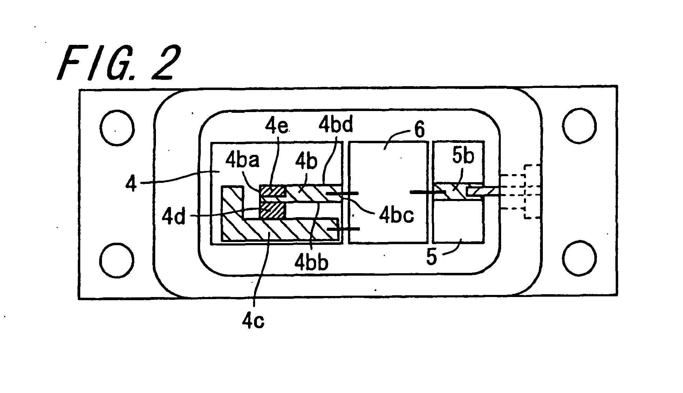

In accordance with the invention a resistor 4e is disposed at the end portion of the line conductor 4b, as shown in Fig. 2. The line width of the line conductor 4b is reduced by cutting away, at the end 4ba side of the line conductor 4b, the side surface 4bd of the line conductor 4b on the side opposite the one side 4bb to which the terminating resistor 4d is connected, and the resistor 4e is disposed in such a way as to fill the cut away portion. The resistor 4e is provided so as to float from the ground potential by arranging in such a way that it is in contact with the conductive portion of the line conductor 4b via a side surface, while other portions, as open ends, are not in contact with any conductor.

By providing the resistor 4e, it is possible to attenuate and suppress resonance occurring in a direction perpendicular to the line conductor 4b from the end 4ba of the line conductor 4b to the terminating resistor 4d and ground conductor 4c. As a result, as it is possible to suppress the reflection of a high frequency signal at the portion of the end 4ba of the line conductor 4b, and radiation outside the high frequency wiring board 4, good terminating characteristics are obtained even with a still higher frequency signal. As a result, it is possible to cause the semiconductor device 6 to operate normally. Also, it is possible to further reduce the radiation of electromagnetic waves into the package, and resonance inside the package due to radiated electromagnetic waves.

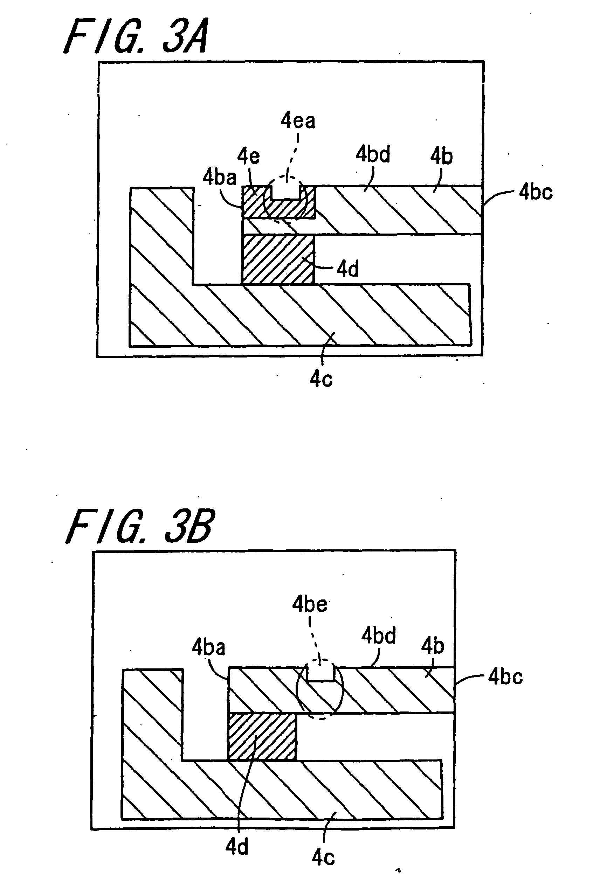

Rather than the line width (the width in a direction perpendicular to the line direction of the line conductor 4b) of the resistor 4e being constant, a region 4ea in which the width is reduced as though the resistor 4e has been cut away may be provided in one portion of the resistor 4e, as shown in Fig. 3A. By providing the region 4ea, it is possible to finely adjust a capacitive constituent with respect to ground held by the resistor 4e, and it is possible to more finely carry out impedance matching of the terminating resistor 4d, meaning that it is possible to obtain better terminating characteristics.

The capacity adjusting region 4ea may be provided in the inner side of the resistor 4e or a portion where the resistor 4e is in contact with the conductive portion of the line conductor 4b, but is preferably provided on the side surface 4bd side of the line conductor 4b. Also, it is preferable to provide the region 4ea at the connecting end 4bc side (the side nearer the one end side 4bc of the line conductor 4b) of the resistor 4e. This is in order to provide the region 4ea outside the capacitive coupling portion between the resistor 4e and the portion of the ground conductor 4c wrapped around to the end 4ba side of the line conductor 4b. This makes it possible to carry out adjustment of the impedance matching while obtaining good terminating characteristics.

Also, instead of providing the region 4ea with the reduced width in the resistor 4e, the capacitive constituent may also be adjusted by providing a region 4be with reduced width in one portion of the line conductor 4b, as shown in Fig. 3B.

With the high frequency wiring board 4, it is preferable that a ground conductor layer 4f is provided on the other main surface (lower surface) of the dielectric substrate 4a, as shown in Figs. 4A and 4B. The ground conductor layer 4f is provided as a continuous surface within a projection plane of at least the line conductor 4b and ground conductor 4c on the other main surface. Normally, the ground conductor layer 4f is provided more widely than the projection plane, for example, over the whole of the lower surface of the dielectric substrate 4a. Then, the ground conductor 4c and ground conductor layer 4f are connected by a connection conductor 4g. In Figs. 4A and 4B, an example is shown wherein the connection conductor 4g is realized by a penetrating conductor 4g provided inside the dielectric substrate 4a. Although not shown in the drawing, it goes without saying that, forming the ground conductor layer 4f and ground conductor 4c as far as a side surface of the dielectric substrate 4a, the connection conductor 4g may be realized by a connection conductor 4g (a side surface conductor) provided in the side surface of the dielectric substrate 4a.

By providing the ground conductor layer 4f, and joining the high frequency wiring board 4 to the base 1 with a metal brazing material, or the like, the ground potential of the ground conductor 4c and line conductor 4b is stable, and good transmission characteristics are obtained even with a high frequency signal.

The base 1 is a rectangular plate-like body formed of a metal such as an Fe-Ni-Co alloy or a metal such as a Cu-W sintered material, or of a dielectric material such as ceramics or resin, and is fabricated in a predetermined form by, for example, subjecting a metal ingot to a heretofore known metal processing such as a rolling or punching, or an injection molding and cutting, etc. The base 1, not being limited to the rectangular plate-like body, may also be a circular or polygonal plate-like body. The high frequency electronic component 6, such as the semiconductor device 6, the high frequency wiring board 4, and the like, are placed in a central portion of the upper side main surface of the base 1, and are securely adhesively fixed to the upper surface of the base 1 using, for example, a brazing material such as an Ag brazing material or an Ag-Cu brazing material, a solder such as an Au-Sn solder or a Pb-Sn solder, or a resin-based adhesive. Examples of the semiconductor device 6 include an IC, an LSI, an LD (laser diode), a PD (photo-diode), another diode, and/or an amplifier. Examples of another electronic component 6 include a light modulating device using, for example, LiNbO₃ (lithium niobate).

In the event that the base 1 is formed of a dielectric material such as ceramics, it is preferable that a conductive layer such as a metalization layer is formed on a surface of the base. By forming the base 1 of a metal or of a dielectric material on which a conductive layer is formed, it is possible to provide a ground potential to the semiconductor device 6 inside via the base 1. This makes it possible to stabilize the operation of the semiconductor device 6.

Electrodes of the semiconductor device 6 are electrically connected to the line conductor 4b which is formed so as to adhere to the upper surface of the high frequency wiring board 4, and another line conductor 5b of another high frequency wiring board 5, or the like, via bonding wires 7a, 7b, and 7c, respectively.

The high frequency wiring board 4 is fabricated by forming the line conductor 4b and the like, on the dielectric substrate 4a, and in the event that the dielectric substrate 4a is formed of, for example, alumina (Al₂O₃) ceramics, the high frequency wiring board 4 is fabricated in the following manner.

Firstly, an appropriate organic binder, plasticizer, dispersant, solvent and the like, are added to and mixed with a raw powder composed of Al₂O₃, silicon dioxide (SiO₂), calcium oxide (CaO), magnesium oxide (MgO) and the like to form a slurry. By forming the slurry into a sheet using a heretofore known doctor blade method, or the like, a ceramic green sheet is obtained. After so doing, by subjecting the ceramic green sheet to an appropriate punching process, the ceramic green sheet is formed into a predetermined shape. Alternatively, the raw powder composed of Al₂O₃, SiO₂, CaO, MgO and the like is loaded into a molding die, and formed into a predetermined shape by carrying out a press molding. Then, the ceramic green sheet is subjected to print-application of a metal paste which is to form the line conductor 4b and ground conductor 4c, on the upper surface thereof, and is fired at a temperature of approximately 1,600°C in a reductive atmosphere, thereby fabricating the high frequency wiring board.

The metal paste which is to form the line conductor 4b and ground conductor 4c, wherein an appropriate organic binder or solvent is added to and mixed with a metal powder with a high melting point such as W, molybdenum (Mo), or manganese (Mn) to form a paste, is print-applied on the ceramic green sheet which is to form the dielectric substrate 4a, or the dielectric substrate 4a formed of ceramics after firing, employing a heretofore known screen printing.

The line conductor 4b and ground conductor 4c may also be formed using a thin film formation method, in which case, the line conductor 4b and ground conductor 4c are formed of tantalum nitride (Ta₂N), nichrome (an Ni-Cr alloy), titanium (Ti), palladium (Pd), platinum (Pt), gold (Au), or the like and, after firing a ceramic green sheet, are formed on one main surface of the dielectric substrate 4a using a vacuum deposition method or the like.

Also, the terminating resistor 4d and resistor 4e are made of a material such as, for example, Ta₂N or an Ni-Cr alloy, and formed by firing after print-application on the high frequency wiring board 4, or formed using a thin film formation method. Also, the terminating resistance value of the terminating resistor 4d and the resistance value of the resistor 4e are set at desired values by appropriately setting the thickness, width, and shape of the terminating resistor 4d or resistor 4e, in accordance with the frequency of a high frequency signal to be transmitted and the characteristic impedance of the line conductor 4b. For example, by removing one portion of the terminating resistor 4d or resistor 4e, using laser processing, in order to make a fine adjustment of the resistance value, it is also possible to accurately adjust the resistance value.

The package for housing the electronic component is such that the frame 2 is joined to a peripheral portion of the upper side main surface of the base 1 in such a way as to stand upright, so as to surround a mounting portion 1a on which the electronic component 6 such as a semiconductor device, the high frequency wiring board 4 and the like are mounted. The frame 2, together with the base 1, forms a space in its interior in which the semiconductor device 6 is housed. The frame 2, in the same way as the base 1, is formed of a metal such as an Fe-Ni-Co alloy or a Cu-W sintered material, or of a dielectric material such as ceramics, and it is formed integrally with the base 1, or is joined to the base 1 by brazing of a brazing material such as an Ag brazing material, or by welding such as seam welding. By this means, the frame 2 is stood upright in the peripheral portion of the upper side main surface of the base 1.

In the event that the frame 2 is formed of a dielectric material such as ceramics, it is preferable that a conductive layer, such as a metalization layer, is formed on a surface thereof. By forming the frame 2 of a metal or of a dielectric material on which a conductive layer is formed, it is possible to block radiation noise occurring due to the semiconductor device 6 inside, or radiation noise infiltrating from the exterior of the frame 2.

Also, as an input-output terminal causing a drive signal, or the like, to be inputted to the semiconductor device 6 from the exterior, for example, a coaxial terminal is installed in the frame 2. The coaxial terminal is formed by a through hole 2a being formed in a side surface of the frame 2, an insulator 11 such as glass beads being fitted inside the through hole 2a, and joined by inserting a sealing material such as an Au-Sn solder or Pb-Sn solder into the gap between it and the through hole 2a, and a central conductor 11a formed of a metal such as an Fe-Ni-Co alloy being fixed in a central shaft of the insulator 11 such as glass beads. The central conductor 11a is electrically connected to the line conductor 5b of the high frequency wiring board 5 via a conductive adhesive material formed of a solder, or the like.

Also, the electrode of the semiconductor device 6 and the line conductor 5b formed on the upper surface of the high frequency wiring board 5 are electrically connected by the bonding wire 7a, and the line conductor 5b and the central conductor 11a are electrically connected via a conductive adhesive material such as a solder.

Then, by housing the semiconductor device 6 inside the package comprising the base 1 and frame 2, joining the lid body 3 to the upper surface of the frame 2 using brazing or welding such as seam welding, and hermetically sealing off the interior of the package, the electronic device becomes a finished product.

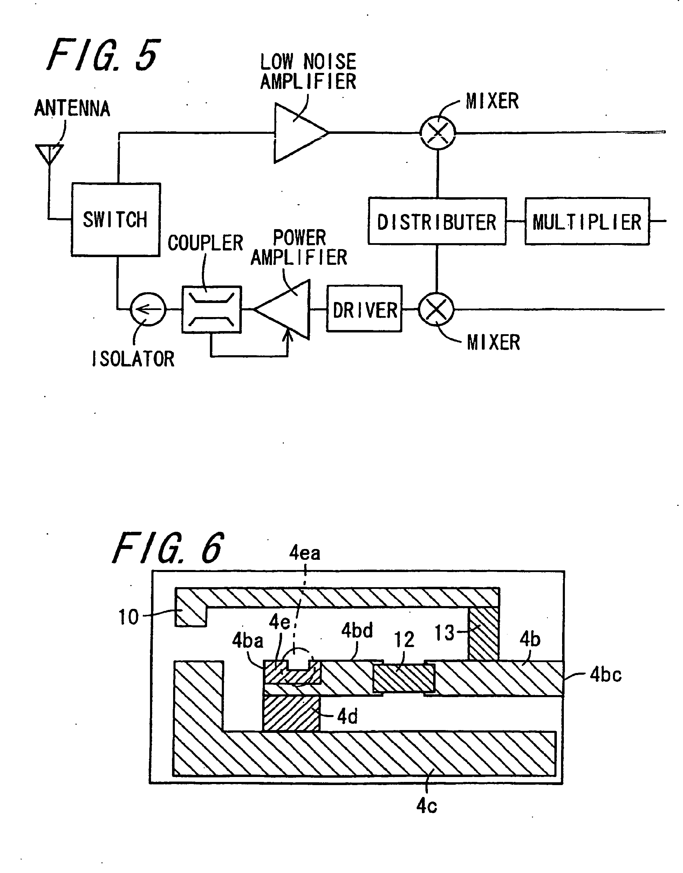

Furthermore, a communication apparatus according to an embodiment of the invention is one in which the above-described electronic device comprising a wigh-frequengy wiring board in accordance with the invention is used in the transceiver circuit block of the communication apparatus shown in Fig. 5, for example. Although an isolator, a coupler, or a mixer circuit is included in Fig. 5, the electronic device is used as an electronic device in a case wherein the semiconductor devices 6 or the like configuring these circuit components are integrated, and the semiconductor devices 6 are terminated.

The communication apparatus according to this embodiment of the invention is such that, because the high frequency wiring board of the invention is used, it is possible to provide a communication apparatus with which stable communication is possible, without interfering with other components or systems inside the communication apparatus.

### Examples

As the high frequency wiring board 4, the line conductor 4b having a width of 0.51 mm, a length of 1.25 mm, and a thickness of 0.002 mm shown in Figs. 1A and 1B was disposed on a substrate, 2 mm long by 3 mm wide, made of alumina ceramics with relative permittivity of 9.6, and the ground conductor 4c was disposed from the one side 4bb of the line conductor 4b to the end 4ba in such a way as to wrap around the end 4ba of the line conductor 4b. The intervals between the end 4ba and one side 4bb of the line conductor 4b and the ground conductor 4c (M and L) were made 0.15 mm. Also, the ground connector 4c was electrically connected by a through hole to the ground conductor layer 4f formed on the lower surface of the high frequency wiring board 4. A sample 1 was set in this way.

Next, as the high frequency wiring board 4 of the invention, the line conductor 4b having a width of 0.51 mm, a length of 1.25 mm, and a thickness of 0.002 mm shown in Fig. 2 was disposed on a substrate, 2 mm long by 3 mm wide, made of alumina ceramics with relative permittivity of 9.6, and furthermore, a cutaway was provided in the end portion of the line conductor 4b, and the resistor 4e was disposed therein. The width (the line width direction) of the cutaway was 0.1 mm, and the length (the line direction) thereof was 0.2 mm, and the resistor 4e having a thickness of 0.002 mm was disposed in this region. Also, the ground conductor 4c was disposed from the one side 4bb of the line conductor 4b to the end 4ba in such a way as to wrap around the end portion of the line conductor 4b. The end 4ba and one side 4bb of the line conductor 4b, and the ground conductor 4c, were set in such a way as to have intervals (M and L) of 0.15 mm. Also, the ground connector 4c was electrically connected by a through hole to the ground conductor layer 4f formed on the lower surface of the high frequency wiring board 4. A sample 2 was set in this way.

Meanwhile, as a comparative example, the line conductor 204b having a width of 0.51 mm, a length of 1.25 mm, and a thickness of 0.002 mm shown in Fig. 8 was disposed on the high frequency wiring board 204, 2 mm long by 3 mm wide, made of alumina ceramics with relative permittivity of 9.6, and a ground conductor 204c having an interval of 0.15 mm with the line conductor 204b was disposed along one side of the line conductor 204b. Also, the ground connector 204c was electrically connected by a through hole to a ground conductor formed on the lower surface of the high frequency wiring board 204. A sample 3 was set in this way.

A return loss S11 of the samples 1 to 3 in a band of 0.5 GHz to 50 GHz was calculated using a high frequency three-dimensional structure simulator (Ansoft HFSS).

As a result, it was found that, the frequency range in which the return loss S11 was -20 dB or less being 36.5 GHz or less with the sample 1, and the frequency range in which the return loss S11 was -20 dB or less being 50 GHz or less with the sample 2, as opposed to the frequency range in which the return loss S11 was -20 dB or less being 13 GHz or less with the sample 3 which was the comparative example, good terminating characteristics were obtained with the high frequency wiring board 4 of the invention up to a high frequency band.

The invention not being limited to one example of the above-described embodiment, various changes are possible provided that they do not depart from the scope of the invention as set out in the claims. For example, in the above-described embodiment example, the package for housing the semiconductor device which houses the high frequency semiconductor device 6, and a semiconductor device, are shown, but it is also possible to use the invention in a package for housing an electronic component which houses a high frequency electronic device 6 such as a light modulating device using LiNbO₃ (lithium niobate), an electronic device, a communication apparatus, and the like. Also, an example is shown wherein the electronic component 6 is joined directly to the base 1 of the package, but there is also a case wherein the electronic component 6 is mounted via an electronic component mounting substrate.

For example, the high frequency wiring board 4 to which this bias T function is added, is shown in Fig. 6. With the high frequency wiring board 4, a bias line 10 is connected via an RF cut resistor 13 to the line conductor 4b. Seen from a connection point of the RF cut resistor 13, a DC cut capacitor 12 is connected to the end 4ba side of the line conductor 4b. The DC cut capacitor 12 prevents a direct current supplied from the bias line 10 from flowing into the ground conductor 4c. Also, the RF cut resistor 13 makes it difficult for an RF signal flowing through the line conductor 4b to flow onto the bias line 10 side. By connecting the bias line 10 to the line conductor 4b in this way, the high frequency wiring board 4 to which the bias T function is added can easily supply a direct current bias to the electronic component 6 connected to the connection end 4bc of the line conductor 4b.

Also, the terms "upper", "lower", "left", and "right" in the description of the above embodiment are used simply for describing positional relationships in the drawings, and do not represent positional relationships when actually using the invention.

The present embodiments are to be considered in all respects as illustrative and not restrictive, the scope of the invention being indicated by the appended claims rather than by the foregoing description and all changes which come within the meaning and the range of equivalency of the claims are therefore intended to be embraced therein.

## Claims

1. A high frequency wiring board (4), comprising:
a dielectric substrate (4a) comprising a first surface;
a line conductor (4b) for high frequency signal transmission provided in a first direction on the first surface and comprising an end portion (4ba); an
a first ground conductor (4c) having a first portion which is disposed along one side of the line conductor (4b) in parallel thereto with a distance therebetween and extends beyord the end portion (4ba) of the line conductor (4b), and a second portion extending perpendiculasly from the first portion so as to intersect a hypothetical extension line extending from said end portion, (4ba) of the line conductor (4b) along the first direction; and
a terminating resistor (4d) configured to electrically connect the end portion (4ba) of the line conductor (4b) and the first portion of the first ground conductor (4c),
**characterized in** further comprising
a second resistor (4e) which is disposed in the end portion of the line conductor (4b) The second resistor (4e) being in contact with line conductor (4b) and not in contact with any other conductor.

2. The high frequency wiring board according to claim 1, wherein a distance (M) between the end (4ba) of the line conductor (4b) and the first ground conductor is equal to or less than a distance (L) between the one side (4bb) of the line conductor (4b) and the first ground conductor (4c).

3. The high frequency wiring board according to claim 1 or 2, wherein the second resistor (4e) comprises a region (4ea) with a narrower width in a direction perpendicular to the first direction.

4. The high frequency wiring board according to claim 3, wherein the region of the second resistor (4e) is provided spaced from the end (4ba) of the line conductor (4b).

5. The high frequency wiring board according to any one of claims 1 to 4, wherein the line conductor (4b) comprises a region (4be) with a narrower width in a direction perpendicular to the first direction.

6. The high frequency wiring board according to any one of claims 1 to 5, further comprising a second ground conductor (4f) electrically connected to the first ground conductor (4c) and formed on a second surface positioned on a second surface of the dielectric substrate (4a) opposite to the first surface.

7. A package for housing an electronic component, comprising:
a base (1);
the high frequency wiring board (4) according to any one of claims 1 to 6, mounted on the upper surface of the base; and
a frame (2) which is joined to a peripheral portion of the upper surface and surrounds the high frequency wiring board.

8. An electronic device, comprising:
the package according to claim 7;
an electronic component (6) mounted inside the package; and
a lid body (3) joined to the upper surface of the frame (2).

9. A communication apparatus, comprising:
the electronic device according to claim 8.

## Patentansprüche

1. Hochfrequenz-Leiterplatte (4), die aufweist:
ein dielektrisches Substrat (4a), das eine erste Oberfläche besitzt,
eine Verbindungs-Leiterbahn (4b) zur Übertragung von Hochfrequenzsignalen, die in einer ersten Richtung auf der ersten Oberfläche vorgesehen ist und einen Endabschnitt (4ba) aufweist,
eine erste Masseanschluss-Leiterbahn (4c), die einen ersten Abschnitt aufweist, der längs einer Seite der Verbindungs-Leiterbahn (4b) parallel dazu und davon beabstandet angeordnet ist und sich über den Endabschnitt (4ba) der Verbindungs-Leiterbahn (4b) hinaus erstreckt, und die einen zweiten Abschnitt aufweist, der sich senkrecht aus dem ersten Abschnitt so erstreckt, dass er eine hypothetische verlängerte Linie schneidet, die sich von dem Endabschnitt (4ba) der Verbindungs-Leiterbahn (4b) längs der ersten Richtung erstreckt,
und
einen Abschlusswiderstand (4d), der so gestaltet ist, dass er den Endabschnitt (4ba) der Verbindungs-Leiterbahn (4b) und den ersten Abschnitt der ersten Masseanschluss-Leiterbahn (4c) elektrisch verbindet,
**dadurch gekennzeichnet, dass** sie ferner aufweist:
einen zweiten Widerstand (4e), der im Endabschnitt der Verbindungs-Leiterbahn (4b) angeordnet ist, wobei der zweite Widerstand (4e) mit der Verbindungs-Leiterbahn (4b) in Kontakt ist und nicht mit irgendeiner anderen Leiterbahn in Kontakt steht.

2. Hochfrequenz-Leiterplatte nach Anspruch 1, bei der ein Abstand (M) zwischen dem Ende der Verbindungs-Leiterbahn (4b) und der ersten Masseanschluss-Leiterbahn gleich einem Abstand (L) zwischen der einen Seite (4bb) der Verbindungs-Leiterbahn (4b) und der ersten Masseanschluss-Leiterbahn (4c) oder kleiner als der Abstand (L) ist.

3. Hochfrequenz-Leiterplatte nach Anspruch 1 oder 2, bei welcher der zweite Widerstand (4e) einen Bereich (4ea) kleinerer Breite in einer Richtung senkrecht zu der ersten Richtung aufweist.

4. Hochfrequenz-Leiterplatte nach Anspruch 3, bei welcher der Bereich des zweiten Widerstands (4e) in einem Abstand von dem Ende (4ba) der Verbindungs-Leiterbahn (4b) vorgesehen ist.

5. Hochfrequenz-Leiterplatte nach einem der Ansprüche 1 bis 4, bei der die Verbindungs-Leiterbahn (4b) einen Bereich (4be) kleinerer Breite in einer Richtung senkrecht zu der ersten Richtung aufweist.

6. Hochfrequenz-Leiterplatte nach einem der Ansprüche 1 bis 5, die ferner eine zweite Masseanschluss-Leiterbahn (4f) aufweist, die elektrisch mit der ersten Masseanschluss-Leiterbahn (4c) verbunden ist und auf einer zweiten Fläche ausgebildet ist, die auf einer zweiten Oberfläche des dielektrischen Substrats (4a) liegt, die der ersten Oberfläche gegenüberliegt.

7. Package zur Aufnahme einer elektronischen Komponente, das aufweist:
ein Unterteil (1),
die Hochfrequenz-Leiterplatte (4) nach einem der Ansprüche 1 bis 6, die auf der oberen Oberfläche des Unterteils angebracht ist,
und
einen Rahmen (2), der an einem Umfangsabschnitt der oberen Oberfläche befestigt ist und die Hochfrequenz-Leiterplatte umgibt.

8. Elektronische Vorrichtung, die aufweist:
das Package nach Anspruch 7,
eine elektronische Komponente (6), die im Inneren des Packages angebracht ist,
und
einen Deckelkörper (3), der mit der oberen Fläche des Rahmens (2) verbunden ist.

9. Kommunikationsvorrichtung, welche die elektronische Vorrichtung nach Anspruch 8 aufweist.

## Revendications

1. Circuit imprimé pour applications à haute fréquence (4), comprenant :
un substrat diélectrique (4a) comprenant une première surface ;
un conducteur d'alimentation (4b) pour la transmission d'un signal à haute fréquence, orienté dans une première direction, placé sur la première surface et comportant une extrémité (4ba) ;
un premier conducteur de masse (4c) comportant une première partie placée le long d'un côté du conducteur d'alimentation (4b), en parallèle et à une certaine distance de ce dernier, s'étendant au-delà de l'extrémité (4ba) du conducteur d'alimentation (4b), et une deuxième partie s'étendant perpendiculairement à la première partie de façon à entrecouper une hypothétique ligne de prolongement de ladite extrémité (4ba) du conducteur d'alimentation (4b) le long de la première direction ; et
une résistance de fermeture (4d) configurée de façon à être reliée électriquement à l'extrémité (4ba) du conducteur d'alimentation (4b) et à la première partie du premier conducteur de masse (4c),
**caractérisé en ce qu'**il comprend également
une deuxième résistance (4e) placée dans l'extrémité du conducteur d'alimentation (4b), la deuxième résistance (4e) ayant un contact avec le conducteur d'alimentation, mais pas avec un quelconque autre conducteur.

2. Circuit imprimé pour applications à haute fréquence selon la revendication 1, dans lequel une distance (M) entre l'extrémité (4ba) du conducteur d'alimentation (4b) et le premier conducteur de masse est égale ou inférieure à une distance (L) entre l'un des côtés (4bb) du conducteur d'alimentation (4b) et le premier conducteur de masse (4c) .

3. Circuit imprimé pour applications à haute fréquence selon les revendications 1 ou 2, dans lequel la deuxième résistance (4e) comporte un emplacement (4ea) présentant une largeur plus étroite orientée dans une direction perpendiculaire à la première direction.

4. Circuit imprimé pour applications à haute fréquence selon la revendication 3, dans lequel l'emplacement de la deuxième résistance (4e) est disposé à une certaine distance de l'extrémité (4ba) du conducteur d'alimentation (4b).

5. Circuit imprimé pour applications à haute fréquence selon l'une quelconque des revendications 1 à 4, dans lequel le conducteur d'alimentation (4b) comprend un emplacement (4be) présentant une largeur plus étroite orientée dans une direction perpendiculaire à la première direction.

6. Circuit imprimé pour applications à haute fréquence selon l'une quelconque des revendications 1 à 5, comprenant également un deuxième conducteur de masse (4f) relié électriquement au premier conducteur de masse (4c) et formé sur une deuxième surface placée sur une deuxième surface du substrat diélectrique (4a) faisant face à la première surface.

7. Boîtier destiné à loger un composant électrique, comprenant :
une base (1) ;
le circuit imprimé pour applications à haute fréquence (4) selon l'une quelconque des revendications 1 à 6, monté sur la face supérieure de la base ; et
un cadre (2) assemblé à la partie périphérique de la face supérieure et entourant le circuit imprimé pour applications à haute fréquence.

8. Un dispositif électrique, comprenant :
le boîtier selon la revendication 7 ;
un composant électrique (6) monté à l'intérieur du boîtier ; et
un couvercle (3) assemblé à la face supérieure du cadre (2).

9. Un appareil de communication, comprenant :
le dispositif électronique selon la revendication 8.
